## Europäisches Patentamt

## European Patent Office

## Office européen des brevets

(11) Publication number:

**0 095 282**
**B1**

(12) **EUROPEAN PATENT SPECIFICATION**

(45) Date of publication of patent specification: **10.12.86**

(21) Application number: **83302656.0**

(22) Date of filing: **10.05.83**

(51) Int. Cl.⁴: $H\ 01\ R\ 9/09$

(54) **Improved contact element.**

(30) Priority: **24.05.82 US 381109**

(43) Date of publication of application:
**30.11.83 Bulletin 83/48**

(45) Publication of the grant of the patent:
**10.12.86 Bulletin 86/50**

(84) Designated Contracting States:
**AT BE CH DE FR GB IT LI NL SE**

(56) References cited:
**US-A-4 186 982**

(73) Proprietor: **AMP INCORPORATED**
**P.O. Box 3608 449 Eisenhower Boulevard**
**Harrisburg Pennsylvania 17105 (US)**

(72) Inventor: **Cobaugh, Robert Franklin**
**Box 382 R.D. No. 2**
**Elizabethtown Pennsylvania 17022 (US)**

(74) Representative: **Gray, Robin Oliver et al**
**BARON & WARREN 18 South End Kensington**
**London W8 5BU (GB)**

EP 0 095 282 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

This invention relates to an elongate contact element of the type having a compliant section for receipt in a plated through hole in a printed circuit board to retain the contact element against movement, the compliant section comprising a split portion defining two legs extending longitudinally and offset along a shear plane provided by the splitting.

A contact element of this kind has been disclosed in US—A—4 186 982 and a contact element having a compliant section of a different form is disclosed in US—A—3 783 433.

The compliant sections of such contact elements are so structured as to yield upon being inserted into a plated through hole in a printed circuit board in such a manner as to exert a strong force against the wall of the hole to retain the section therein but without destroying the wall and plating.

It is an object to provide an improved contact element of the type to which the invention relates in which hole distortion is reduced in use and improved stability and retention obtained.

According to the invention the contact element is characterised in that a stabilizer section is provided on the contact element immediately adjacent the compliant section, said stabilizer section including bevelled or radiused surfaces leading from the legs to opposite lateral sides having corners and extending parallel to the shear plane with the distance between the opposite sides and the diagonal distance between corners being such that upon inserting the stabilizer section in the hole, the corners of the sides will at least bear against the wall of the hole.

Suitably the legs are prestressed by being initially spread apart in opposite directions and then pushed back towards each other to a predetermined relative position to resize the compliant section. This feature also forms the subject of a divisional European patent application having the application number 85.201199.8.

The invention will now be described, by way of example, with reference to the accompanying partly diagrammatic drawings, in which:—

FIGURE 1 is an isometric view of a portion of a contact element including the compliant section and the stabilizer section added thereto in accordance with the present invention;

FIGURE 2 is a cross-sectional view of a plated through hole in a printed circuit board showing the compliant section of Figure 1 positioned therein;

FIGURES 3a and 3b are views taken along lines 3—3 of Figure 2; and

FIGURES 4a, 4b and 4c are cross-sectional views illustrating over-forming and resizing the compliant section of the contact element in accordance with the present invention.

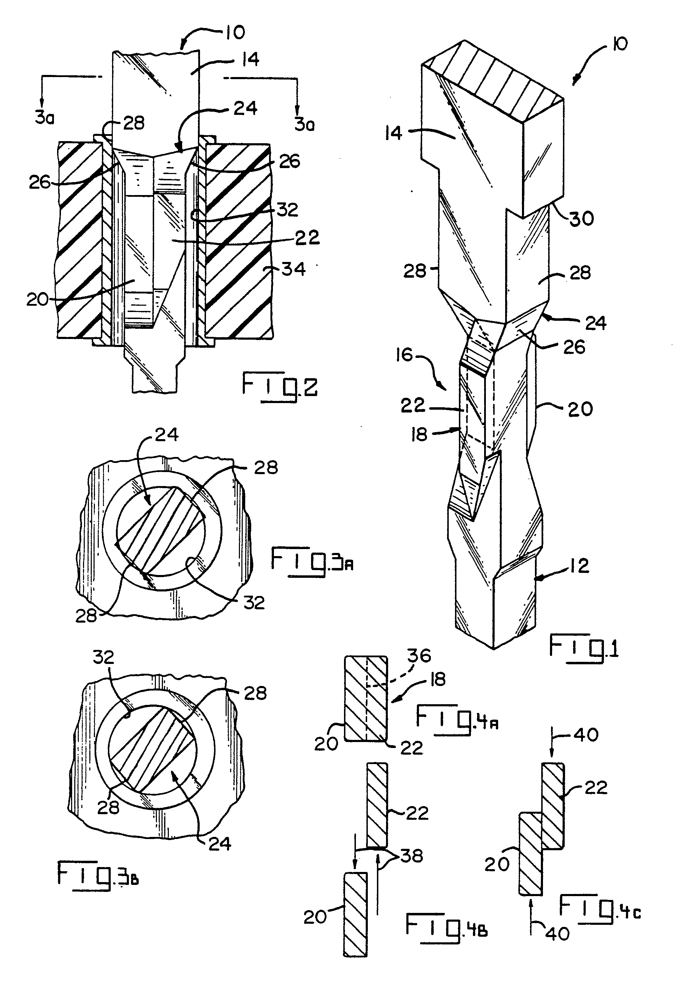

With reference to Figure 1, contact element 10 includes a lower section 12 which may be a post extending below a circuit board for wire wrapping or like purposes. Further, the element includes an upper section 14, of which only a small portion is shown, which may be a wire-wrap post, a spring-contact section for use in a card edge connector (not shown) or some other similar structure.

The compliant section is in between the aforementioned sections and is indicated generally by reference numeral 16. For a complete description of the compliant section, inquiry may be made to U.S. Patent No. 4,186,982. Generally, the compliant section includes a split portion 18, the split defining two legs 20 and 22. The legs are offset with respect to each other along the shear plane provided by the splitting.

The stabilizer section of the present invention is located immediately above compliant section 16 and is indicated by reference numeral 24. The section includes opposing beveled or radiused surfaces 26 and sides 28 up to shoulders 30. Note that the stabilizer section is parallel to the shear plane separating legs 20 and 22. In other words, the beveled surfaces are rotated ninety degrees relative to the direction in which the legs move. The beveled surfaces are preferably at an angle of about thirty degrees relative to the vertical.

The critical dimension of the stabilizer section is the length of a diagonal line between opposing corners on sides 28. Ideally, that dimension will be equal to the diameter of the smallest or minimum plated through hole on a circuit board; i.e., the specified hole diameter ·less the permitted tolerance.

Figure 2 shows the compliant and stabilizer sections positioned in plated through hole 32 in circuit board 34. The drawing shows stabilizer section 24 engaging the wall of the plated through hole adjacent the top surface of board 34. The beveled surfaces 26 facilitates the insertion particularly where hole 32 is undersized; i.e., of a minimum diameter. In this case, the beveled surfaces and sides 28 will displace some of the plating as shown in Figure 3a. In extreme cases, the hole may be slightly distorted. Should the diameter of hole 32 be at a maximum diameter, sides 28 will just bear against the wall without disturbing the plating. This case is shown in Figure 3b.

A second improvement to contact element 10 involves compliant section 18. The improvement provides pre-stressing legs 20 and 22 by pushing them apart and then pushing them back towards each other to the desired size. Figures 4a, 4b and 4c illustrate the aforementioned improvement. Figure 4a shows the compliant section with a dashed line 36 being the slit forming legs 20 and 22. Thereafter, the legs are pushed apart in the direction of arrows 38 in Figure 4b and along the shear plane. The separation is preferably complete; i.e., the legs are completely separated one from the other. Lastly, the legs are pushed back towards each other as indicated by arrows 40 in Figure 4c; i.e., the legs are resized to a predetermined dimension.

The aforementioned improvement has provided substantially lower hole distortion and a significant decrease in force required to drive the contact element into the hole. Further, with the force required to insert a compliant section with resized legs being reduced the vulnerability of the contact elements to buckling is much less.

Tests show that the difference in force required to push an element out of a plated through hole is not measurably significant for a resized compliant section from that for an element without this improvement.

Further, tests have shown that the stabilizer section is very effective in returning the contact element to a vertical position after a deforming load was removed from an end. Also, the degree of movement did not increase over time during tests which subjected the elements to deforming loads in various directions. This indicates that the stabilizer section prevents cumulative loss in stability from multiple disturbances.

In summary, tests clearly indicate that contact elements incorporating the novel improvements disclosed herein cause less hole distortion, locks the elements in the hole as securely as for non-improved elements and has greater stability against deforming horizontal loads.

## Claims

1. An elongate contact element (10) of the type having a compliant section (16) for receipt in a plated through hole (32) in a printed circuit board (34) to retain the contact element (10) against movement, the compliant section (16) comprising a split portion defining two legs (20, 22) extending longitudinally and offset along a shear plane provided by the splitting, characterised in that a stabilizer section (24) is provided on the contact element (10) immediately adjacent the compliant section (16), said stabilizer section (24) including bevelled or radiused surfaces (26) leading from the legs (20) to opposite lateral sides (28) having corners and extending parallel to the shear plane with the distance between the opposite sides and the diagonal distance between corners being such that upon inserting the stabilizer section (24) into the hole (32), the corners of the sides (28) will at least bear against the wall of the hole (32).

2. A contact element (10) as claimed in claim 1, characterised in that the legs (20, 22) are prestressed by being initially spread apart in opposite directions and then pushed back towards each other to a predetermined relative position to resize the compliant section (16).

## Patentansprüche

1. Längliches Kontaktelement (10) des Typs, das einen nachgiebigen Abschnitt (16) zur Aufnahme in einem durchplattierten Loch (32) in einer gedruckten Schaltungsplatte (34) aufweist, um das Kontaktelement (10) gegen die Ausführung einer Bewegung festzuhalten, wobei der nachgiebige Abschnitt (16) einen gespaltenen Bereich umfaßt, der zwei Schenkel (20, 22) definiert, die sich in Längsrichtung erstrecken und längs einer durch die Spaltung geschaffenen Scherebene versetzt angeordnet sind, dadurch gekennzeichnet, daß ein Stabilisierabschnitt (24) an dem Kontaktelement (10) unmittelbar angrenzend an den nachgiebigen Abschnitt (16) vorgesehen ist, wobei der Stabilisierabschnitt (24) ageschrägte oder gerundete Flächen (26) beinhaltet, die von den Schenkeln (20) zu einander entgegengesetzten Seiten (28) führen, die Ecken aufweisen und sich parallel zur Scherebene erstrecken, wobei der Abstand zwischen den einander entgegengesetzten Seiten und der diagonale Abstand zwischen den Ecken derart ausgebildet sind, daß nach dem Einführen des Stabilisierabschnitts (24) in das Loch (32) die Ecken der Seiten (28) wenigstens in abstützender Weise an der Wand des Lochs (32) angreifen.

2. Kontaktelement (10) nach Anspruch 1, dadurch gekennzeichnet, daß die Schenkel (20, 22) dadurch vorgespannt sind, daß sie zuerst in entgegengesetzten Richtungen auseinandergespreizt und dann bis auf eine vorbestimmte Relativposition in Richtung aufeinander zu zurückgedrückt worden sind, um den nachgiebigen Abschnitt (16) auf richtige Größe zurückzubringen.

## Revendications

1. Elément de contact allongé (10) du type comportant un tronçon souple (16) destiné à être reçu dans un trou métallisé (32) traversant une plaquette (34) à circuit imprimé afin d'empêcher tout mouvement de l'élément de contact (10), le tronçon souple (16) comprenant une partie fendue définissant deux branches (20, 22) s'étendant longitudinalement et décalées suivant un plan de cisaillement formé par le fendage, caractérisé en ce qu'un tronçon stabilisateur (24) est prévu sur l'élément de contact (10), à proximité immédiate du tronçon souple (16), ledit tronçon stabilisateur (24) présentant des surfaces biseautées ou arrondies (26) menant des branches (20) jusqu'à des côtés latéraux opposés (28) possédant des angles et s'étendant parallèlement au plan de cisaillement, la distance comprise entre les côtés opposés et la distance mesurée en diagonale entre les angles étant telles que, lors de l'insertion du tronçon stabilisateur (24) dans le trou (32), les angles des côtés (28) portent, pour le moins, contre la paroi du trou (32).

2. Elément de contact (10) selon la revendication 1, caractérisé en ce que les branches (20, 22) sont précontraintes en étant initialement écartées l'une de l'autre dans des directions opposées, puis repoussées l'une vers l'autre jusqu'à une position relative prédéterminée pour redimensionner le tronçon souple (16).

Fig.2

Fig.3A

Fig.3B

Fig.1

Fig.4A

Fig.4B

Fig.4C